# EUROPÄISCHE PATENTSCHRIFT

(11) **EP 0 462 135 B1**
(45) Veröffentlichungstag und Bekanntmachung des Hinweises auf die Patenterteilung: **07.09.1994**
(21) Anmeldenummer: 90903825.9
(22) Anmeldetag: 03.03.1990
(51) Int. Cl.: C23C 16/30, C30B 25/02, C30B 29/40, C07F 5/00, C07F 5/06, C07F 9/70, C07F 9/90

(54) **METALLORGANISCHE ADDUKTVERBINDUNGEN**
METALLO-ORGANIC ADDUCT COMPOUNDS
PRODUITS D'ADDITION ORGANO-METALLIQUES

(30) Priorität: 09.03.1989 DE 3907581
(43) Veröffentlichungstag der Anmeldung: 27.12.1991
(73) Patentinhaber: MERCK PATENT GmbH, D-64271 Darmstadt (DE)
(72) Erfinder: HOSTALEK, Martin, D-6100 Darmstadt (DE); LOKAI, Matthias, D-6753 Enkenbach-Alsenborn (DE); POHL, Ludwig, D-6100 Darmstadt (DE)
(86) Internationale Anmeldenummer: EP9000357
(87) Internationale Veröffentlichungsnummer: WO9010727

(56) Entgegenhaltungen:
- EP-A- 0 080 349
- EP-A- 0 080 844
- EP-A- 0 251 555
- WO-A-86/03228
- Journal of Crystal Growth, Band 92, Nrn. 1,2, 1. October 1988, Elsevier Science Publishers B.V. (North-Holland Physics Publishing Division), (Amsterda, NL), D.C. Bradley et al.:"The volatilities of some adducts of trimethylindium", Seiten 37-45
- Journal of Crystal Growth, Band 91, Nrn. 1,2, August 1988, Elsevier Science Publishers B.V. (North-Holland Physics Publishing Division ), (Amsterdam, NL), F. Maury et al.: "Mass spectrometric study of the pyrolysis of organometallic precursors usable in GaAs vapor phase epitaxy", Seiten 97-104
- Journal of Crystal Growth, band 69, November 1984, Else Science Publishers B.V. (North-Holland Physics Publishing Division), (Amsterdam, NL), J.A. long et al .: "Growth of Fe-doped semi-insulating InP by MOCVD", seiten 10-14

## Beschreibung

Die Erfindung betrifft die Verwendung von metallorganischen Adduktverbindungen, die Aluminium, Gallium oder Indium als Metalle enthalten, für die Herstellung dünner Filme oder epitaktischer Schichten durch Gasphasenabscheidung sowie neue, Gallium oder Indium enthaltende Addukte.

Die Abscheidung solcher Schichten aus entweder reinen Elementen der dritten Gruppe oder aus Kombinationen mit anderen Elementen, wie z.B. Galliumarsenid, Indiumphosphid oder Galliumphosphid, kann zur Herstellung von elektronischen und optoelektronischen Schaltelementen, Verbindungshalbleitern und Lasern verwendet werden. Die Abscheidung dieser Schichten erfolgt aus der Gasphase.

Die Eigenschaften dieser Filme hängen von den Abscheidungsbedingungen und der chemischen Zusammensetzung des abgeschiedenen Films ab.

Für die Abscheidung aus der Gasphase kommen alle bekannten Methoden wie die Metal-Organic Chemical Vapour Deposition (MOCVD) Methode, die Photo-Metal-Organic Vapour Phase (Photo-MOVP) Methode, bei welcher die Substanzen durch UV-Bestrahlung zersetzt werden, die Laser-Chemical Vapour Deposition (Laser CVD) Methode oder die Metal-Organic Magnetron Scattering (MOMS) Methode in Frage. Die Vorteile gegenüber anderen Methoden sind ein kontrollierbares Schichtenwachstum, eine genaue Dotierungskontrolle sowie eine aufgrund der Normal- oder Niederdruckbedingungen einfache Handhabung und Produktionsfreundlichkeit.

Bei der MOCVD-Methode werden metallorganische Verbindungen eingesetzt, die sich unter Abscheidung des Metalls bei einer Temperatur unterhalb 1100 °C zersetzen. Typische Apparaturen, die zur Zeit für MOCVD benutzt werden, bestehen aus einem "bubbler" mit einer Zufuhr für die metallorganische Komponente, einer Reaktionskammer, die das zu beschichtende Substrat enthält, sowie einer Quelle für ein Trägergas, das gegen die metallorganische Komponente inert sein soll. Der "bubbler" wird auf einer konstanten, relativ niedrigen Temperatur gehalten, die vorzugsweise über dem Schmelzpunkt der metallorganischen Verbindung, aber weit unterhalb der Zersetzungstemperatur liegt. Die Reaktions- oder Zersetzungskammer hat vorzugsweise eine sehr viel höhere Temperatur, die unterhalb 1100 °C liegt, bei welcher die metallorganische Verbindung sich vollständig zersetzt und das Metall abgeschieden wird. Durch das Trägergas wird die metallorganische Verbindung in den Dampfzustand gebracht und mit dem Trägergas in die Zersetzungskammer geschleust. Der Massenfluß des Dampfes ist gut zu kontrollieren, und somit ist auch ein kontrolliertes Wachsen der dünnen Schichten möglich.

Bislang wurden für die Gasphasenabscheidung hauptsächlich Metallalkyle wie z.B. Trimethylgallium, Trimethylaluminium oder Trimethylindium verwendet. Diese Verbindungen sind jedoch extrem luftempfindlich, selbstentzündlich und teilweise bereits bei Raumtemperatur zersetzlich. Daher sind für die Herstellung, den Transport, die Lagerung und die Anwendung dieser Verbindungen aufwendige Vorsichtsmaßnahmen notwendig. Es sind auch einige etwas stabilere Addukte der Metallalkyle mit Lewisbasen wie z.B. Trimethylamin und Triphenylphosphin bekannt (z.B. beschrieben in GB 21 23 422, EP-A 108 469 oder EP-A 176 537), die jedoch aufgrund des geringen Dampfdruckes nur bedingt für die Gasphasenabscheidung geeignet sind.

Diese bekannten Addukte enthalten jedoch im Gegensatz zu den erfindungsgemäß verwendeten Adduktverbindungen keine Wasserstoffatome als Rest am V-Element.

Aus der DE-OS 36 31 469 sind metallorganische Verbindungen, die für die MOCVD-Technik geeignet sind, bekannt. Die dort beschriebenen Verbindungen stellen jedoch keine Addukte, sondern Verbindungen, die intramolekular stabilisiert sind, dar.

Aufgabe der vorliegenden Erfindung war es nun, metallorganische Adduktverbindungen zu finden, die einfach handhabbar und bei Raumtemperatur stabil sind, und die einen genügend hohen Dampfdruck aufweisen, um sich aus der Gasphase zersetzen zu lassen, also für die verschiedenen Methoden der Gasphasenabscheidung geeignet sind.

Es wurde nun gefunden, daß sich metallorganische Adduktverbindungen der III. und V. Hauptgruppe, wobei die Verbindung der V. Hauptgruppe ein oder zwei Wasserstoffatome enthält, hervorragend für die Gasphasenabscheidung eignen.

Diese Addukte haben einen entscheidenen Vorteil gegenüber den bisher verwendeten und bekannten metallorganischen Addukten der Struktur R₃MXR₃, die also ausschließlich Alkyl- oder Arylgruppen enthalten.

Die erfindungsgemäßen Addukte mit mindestens einem H-Atom am Element der V. Hauptgruppe reagieren bei höheren Temperaturen (> 100 °C) unter Abgabe von R*H (wobei R* R¹, R² oder R³ ist) zu Verbindungen der Struktur R*₂MXR⁴R⁵. In diesen Verbindungen ist die MX-Bindung gegenüber den am Metall der III. Hauptgruppe gebundenen Gruppen als schwach anzusehen, und somit stellt die Gruppe XR⁴R⁵ eine sehr gute Abgangsgruppe dar. Im MOCVD-Prozeß führt daher die in situ auf dem heißen Wafer erzeugte Substanz R*₂MXR⁴R⁵ zu einem verminderten C-Einbau.

Stabilisierte Addukte dieser Art sind zum Teil beschrieben, jedoch nur im Zusammenhang mit Strukturuntersuchungen, Komplexbildungs- oder Stabilitätsuntersuchungen. Teilweise sind die Verbindungen der Formel I noch neu. Journal of Crystal Growth, Band 92, Nr.1-2, Seiten 37-45 (1988) behandelt Untersuchungen zur Flüchtigkeit von einigen Trimethylindiumaddukten, unter anderem von Me₃ In-NH(C₆H₁₁)₂.

Gegenstand der Erfindung ist daher die Verwendung von metallorganischen Adduktverbindungen der Formel I 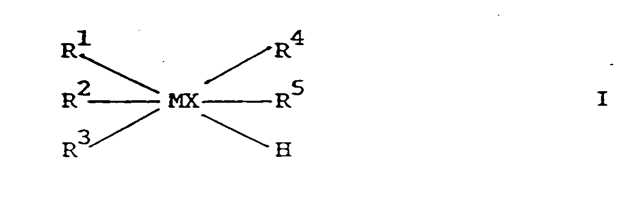
worin
- M: Aluminium, Gallium oder Indium,
- X: Stickstoff, Phosphor, Arsen oder Antimon,
- R¹, R², R³ und R⁴: jeweils unabhängig voneinander H, eine Alkylgruppe mit 1-8 C-Atomen, die auch teilweise oder vollständig fluoriert sein kann, oder eine Alkenylgruppe mit 3-8 C-Atomen
und
- R⁵: eine Alkylgruppe mit 1-8 C-Atomen, die auch teilweise oder vollständig fluoriert sein kann, oder eine Alkenylgruppe mit 3-8 C-Atomen
bedeuten,
als Ausgangsprodukte für die Herstellung dünner Filme oder epitaktischer Schichten durch Gasphasenabscheidung sowie ein Verfahren zur Herstellung dünner Filme oder epitaktischer Schichten durch Gaspbasenabscheidung aus metallorganischen Verbindungen, bei dem als metallorganische Verbindungen die Verbindungen der Formel I eingesetzt werden. Ferner ist Gegenstand der Erfindung, daß man bei dem erfindungsgemäßen Verfahren während des Abscheidungsprozesses eine oder mehrere unter den angewandten Reaktionsbedingungen gasförmige Verbindungen des Arsens, Antimons oder Phosphors zuführt.

Weiterhin sind Gegenstand der Erfindung auch die neuen Addukte der Formel I, die der Formel II entsprechen 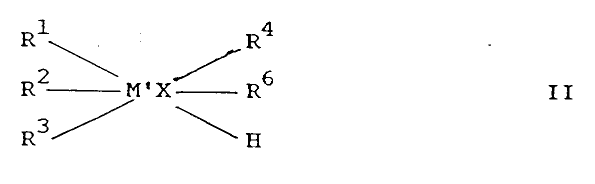
worin
- M': Gallium oder Indium,
- X: Stickstoff, Phosphor, Arsen oder Antimon,
- R¹, R², R³ und R⁴: jeweils unabhängig voneinender H, eine Alkylgruppe mit 1-8 C-Atomen, die auch teilweise oder vollständig fluoriert sein kann, oder eine Alkenylgruppe mit 3-8 C-Atomen
und
- R⁶: eine verzweigte Alkylgruppe mit 3-8 C-Atomen, die teilweise oder vollständig fluoriert sein kann,
bedeuten.

Die Stabilität der Addukte der Formeln I und II beruht auf der Elektronenübertragung vom Stickstoff-, Phosphor-, Arsen- oder Antimonatom auf das elektronenarme III B-Elemente. Diese Addukte zeigen daher eine hohe Stabilität gegenüber Luft und Sauerstoff, sie sind nicht mehr selbstentzündlich und damit einfach zu handhaben.

In der Gasphase jedoch lassen sich die erfindungsgemäßen Verbindungen leicht unter Abscheidung des Metalls zersetzen. Da die Verbindungen der Formeln I und II stabile und gut abspaltbare Abgangsgruppen enthalten, resultiert ein geringerer Einbau an Kohlenstoff, was für die Qualität der Endprodukte große Vorteile hat.

Die abgeschiedenen Filme können sowohl aus dem reinen IIIB-Element, als auch aus Kombination mit Elementen der V. Gruppe auf beliebigen Substraten gebildet werden. Sie können je nach Substrat und Abscheidetechnik epitaktischer Natur sein. Viele der Addukte der Formeln I und II sind auch deshalb besonders gut für die MOCVD-Methode geeignet, da sie als Monomere und damit zumeist bei Raumtemperatur als Flüssigkeiten vorliegen.

Die Addukte der Formeln I und II weisen einen für die MOCVD-Technik geeigneten Dampfdruck auf und sind daher hervorragend als Ausgangsprodukte geeignet.

In Formel I bedeutet M Aluminium (Al), Gallium (Ga) oder Indium (In), vorzugsweise Ga oder In.

Besonders bevorzugte Verbindungen der Formel I sind die neuen Addukte der Formel II, worin M' Ga oder In ist.

X in den Formeln I und II bedeutet in erster Linie bevorzugt Stickstoff, in zweiter Linie bevorzugt Phosphor oder Arsen.

Die Reste R¹, R², R³ und R⁴ in den Formeln I und II bedeuten vorzugsweise jeweils H oder eine geradkettige oder verzweigte Alkylgruppe mit 1-8 C-Atomen, vorzugsweise mit 1-5 C-Atomen Die Alkylgruppen sind vorzugsweise geradkettig und bedeuten demnach bevorzugt Methyl, Ethyl, Propyl, Butyl, Pentyl, ferner auch Hexyl, Heptyl, Octyl, iso-Propyl, sek.-Butyl, tert.-Butyl, 2-Methylpentyl, 3-Methylpentyl oder 2-Octyl. Die Alkylreste können teilweise oder auch vollständig fluoriert sein und z.B. Monofluormethyl, Trifluormethyl, Difluorethyl, Trifluorethyl, Pentafluorethyl oder Trifluorpropyl bedeuten. Vorzugsweise bedeutet nur einer der Reste R¹, R², R³ oder R⁴ H.

Vorzugsweise stellen R¹, R², R³ und/oder R⁴ auch Alkenylgruppen mit 3-8 C-Atomen, vorzugsweise mit 3-5 C-Atomen dar. Sie bedeuten demnach vorzugsweise Propenyl, Butenyl, Pentenyl ferner Hexenyl, Heptenyl oder Octenyl.

Weiterhin sind Verbindungen der Formeln I und II bevorzugt, worin R¹, R², R³ und/oder R⁴ eine Arylgruppe bedeuten. Dabei ist vorzugsweise Aryl gleichbedeutend mit einer Phenylgruppe. Diese Phenylgruppe kann auch substituiert vorliegen. Da diese Substituenten keinen wesentlichen Einfluß auf den augestrebten Verwendungszweck ausüben, sind alle Substituenten erlaubt, die keinen störenden Einfluß auf die Zersetzungsreaktion haben.

R⁵ in Formel I bedeutet vorzugsweise eine Alkylgruppe mit 1-8 C-Atomen, vorzugsweise mit 1-5 C-Atomen. Sie kann geradkettig oder verzweigt sein, ist vorzugsweise verzweigt und bedeutet demnach vorzugsweise iso-Propyl, sek.-Butyl, tert.-Butyl, ferner bevorzugt auch 2-Methylpentyl, 3-Methylpentyl, 2-Octyl, Methyl, Ethyl, Propyl, Butyl, Hexyl, Heptyl oder Octyl.

Der Alkylrest in R⁵ kann auch teilweise oder vollständig fluoriert sein und bedeutet dann vorzugsweise Monofluormethyl, Trifluormethyl, Difluorethyl, Trifluorethyl, Pentafluorethyl oder Trifluorpropyl.

R⁶ in Formel II stellt eine verzweigte Alkylgruppe mit 3-8 C-Atomen, vorzugsweise mit 3-5 C-Atomen, dar, die auch teilweise oder vollständig fluoriert sein kann. R⁶ bedeutet demnach bevorzugt iso-Propyl, sek.-Butyl, tert.-Butyl, 1-Methylbutyl, 2-Methylbutyl, 1,2-Dimethylpropyl, ferner auch 2-Methylpentyl, 3-Methylpentyl, 2-Octyl oder 2-Hexyl.

Die neuen Addukte der Formel II enthalten also in dem Teil mit dem Element der V. Gruppe mindestens eine verzweigte Alkylgruppe und mindestens ein Wasserstoffatom.

Folgende Gruppe von Verbindungen der Formel II sind besonders bevorzugt:
(Methyl)₃ Ga NH (i-Propyl)₂
(Ethyl)₃ Ga NH (i-Propyl)₂
(Methyl)₃ In NH (i-Propyl)₂
(Ethyl)₃ In NH (i-Propyl)₂
(Methyl)₃ Ga AsH₂ (i-Propyl)
(Methyl)₃ Ga AsH (i-Propyl)₂
(Ethyl)₃ Ga AsH₂ (tert.Butyl)
(Ethyl)₃ Ga NH (sek.Butyl)₂
R¹R²R³ Ga NH₂ (tert.Butyl)
R¹R²R³ Ga NH₂ (2-Octyl)
R¹R²R³ Ga NH₂ (2-Methylpentyl)
R¹R²R³ In PH (i-Propyl)₂
R¹R²R³ In PH₂ (i-Propyl)
R¹R²R³ In PH (sek. Butyl)₂
R¹R²R³ In PH (tert. Butyl)₂
R¹R²R³ In PH₂ (3-Methylpentyl)
R¹R²R³ In NH₂ (tert.Butyl)
R¹R²R³ In NH (2-Octyl)₂
Diese Verbindungen stellen ebenfalls bevorzugte Addukte der Formel I dar. Weitere bevorzugte Addukte der Formel I sind folgende:
(Methyl)₃ Al NH (Ethyl)₂
(Methyl)₃ Al NH₂ (Ethyl)
(Ethyl)₃ Al NH (Ethyl)₂
(Ethyl)₃ Al NH (i-Propyl)₂
(Propyl)₃ Al NH₂ (Methyl)
(Ethyl)₃ Ga NH (Ethyl)₂
(Ethyl)₃ In NH (Methyl)₂
(Ethyl)₃ Ga AsH (Pentyl)₂
(Methyl)₃ Ga AsH₂ (Butyl)
(i-Propyl)₃ In PH (Ethyl)₂
Die Verbindungen der Formeln I und II sind hervorragend für die MOCVD-Epitaxie bzw. MOCVD-Methode geeignet, da sie sich bei höheren Temperaturen unter Freisetzung des entsprechenden Metalles zersetzen. Sie sind ebenfalls für die anderen Methoden der Gasphasenabscheidung wie Photo-MOVP, Laser-CVD oder MOMS geeignet.

Die Verbindungen der Formeln I und II werden nach an sich bekannten Methoden hergestellt, wie sie in der Literatur (z.B. G. Bähr, P. Burba, Methoden der organischen Chemie, Band XIII/4, Georg Thieme Verlag, Stuttgart (1970)) beschrieben sind, und zwar unter Reaktionsbedingungen, die für die genannten Umsetzungen bekannt und geeignet sind. Dabei kann man auch von an sich bekannten, hier nicht näher erwähnten Varianten Gebrauch machen.

Beispielsweise können die Addukte durch direkte Umsetzung der entsprechenden Verbindungen der III-Elemente (R¹R²R³M oder R¹R²R³M') mit den Verbindungen enthaltend das Element der V. Gruppe (XHR⁴R⁵ oder XHR⁴R⁶) hergestellt werden. Eine andere Möglichkeit besteht darin, ein entsprechendes Etherderivat der III-Verbindung mit der V-Verbindung umzusetzen, wobei ein Ligandenaustausch erfolgt (beispielsweise schon beschrieben von G. Bähr, P. Burba, Houben-Weyl, Band 13/4 S. 338, Georg Thieme Verlag, Stuttgart (1970)).

Beim erfindungsgemäßen Verfahren zum Herstellung dünner Filme oder epitaktischer Schichten auf beliebigen Substraten setzt man bei den an sich bekannten Gasphasenabscheidungs-Prozessen von metallorganischen Verbindungen als Ausgangsverbindungen die stabilisierten metallorganischen Adduktverbindungen der Formel I ein. Die Reaktionsbedingungen können analog den aus der Literatur bekannten und dem Fachmann geläufigen Werten gewählt werden.

Zur Herstellung von Verbindungshalbleitern, elektronischen und optoelektronischen Bauteilen können beim erfindungsgemäßen Verfahren während des Abscheidungsprozesses in der Zersetzungskammer eine oder mehrere unter den angewandten Reaktionsbedingungen gasförmige Verbindungen des Arsens, Antimons oder Phosphors, beispielsweise AsH₃, As(CH₃)₃, PH₃ oder SbH₃, zusätzlich zugesetzt werden. Eine weitere Variante des erfindungsgemäßen Verfahrens besteht darin, daß man während des Abscheidungsprozesses zusätzlich zu den erfindungsgemäßsen metallorganischen Addukten der Formel I Dotierstoffe zusetzt. Als Dotierstoffe werden dabei flüchtige metallorganische Verbindungen von Eisen, Magnesium, Zink oder Chrom eingesetzt. Als bevorzugte Verbindungen gelten dabei z.B. Zn(CH₃)₂, Mg(CH₃)₂ oder Fe(C₅H₅)₂.

Ferner ist es möglich, die Verbindungen der Formel I als Dotierstoffe während des Abscheidungsprozesses anderer metallorganischer Verbindungen zuzusetzen.

Die nach den erfindungsgemäßen Verfahren hergestellten Schichten können verwendet werden für die Herstellung von elektronischen und optoelektronischen Schaltelementen, Verbindungshalbleitern oder Lasern.

Da bei den momentan im Einsatz befindlichen Epitaxieanlagen aus thermodynamischen Gründen nur ca. 1-10 % der eingesetzten freien Metallalkyle als Epitaxieschicht auf dem Substrat abgeschieden werden kann, stellt die Vernichtung der überschüssigen Metallalkyle, die aufgrund ihrer extremen Empfindlichkeit nicht zurückgewonnen werden können, ein erhebliches Problem dar. Die erfindungsgemäßen Verbindungen der Formel I eröffenen dagegen aufgrund ihrer hohen Stabilität neue Möglichkeiten zur gefahrlosen Vernichtung oder zur Rückgewinnung der wertvollen III B-Verbindungen.

Die folgenden Beispiele sollen die Erfindung näher erläutern, ohne sie zu begrenzen. Temperaturangaben erfolgen in Grad Celsius oder Kelvin. Fp. bedeutet Schmelzpunkt und Kp. Siedepunkt.

### Beispiel 1

Zu 30,6 g (0,27 Mol) Trimethylgalliumdiethyletherat gibt man 270 g (0,27 Mol) Diisopropylamin. Anschließend wird der Ether abdestilliert und das Produkt fraktioniert destilliert. Man erhält (Methyl)₃ Ga NH (i-Propyl)₂ mit Kp. 138 °C.

Analog werden hergestellt:
(Methyl)₃ Ga NH (Propyl)₂
(Methyl)₃ Ga NH (sek. Butyl)₂
(Methyl)₃ Ga NH (tert.Butyl)₂
(Methyl)₃ Ga NH₂ (Ethyl)
(Methyl)₃ Ga NH₂ (i-Propyl)
(Ethyl)₃ Ga NH (i-Propyl)₂
(Ethyl)₃ Ga NH (Propyl)₂
(Ethyl)₃ Ga NH (sek. Butyl)₂
(Ethyl)₃ Ga NH (tert.Butyl)₂
(Ethyl)₃ Ga NH₂ (Methyl)
(Ethyl)₃ Ga NH₂ (i-Propyl)

### Beispiel 2

Analog Beispiel 1 erhält man durch Umsetzung von 61,0 g (0,26 Mol) Trimethylindiumdiethyletherat und 101,0 g (0,26 Mol) Diisopropylamin bei 20° das (Methyl)₃ In NH(i-Propyl)₂ mit Kp. 69° bei 10 mbar.

Analog werden hergestellt:
(Methyl)₃ In NH (Propyl)₂
(Methyl)₃ In NH (Ethyl)₂
(Methyl)₃ In NH (sek.Butyl)₂
(Methyl)₃ In NH (tert.Butyl)₂
(Methyl)₃ In NH₂ (Ethyl)
(Methyl)₃ In NH₂ (i-Propyl)
(Ethyl)₃ In NH (i-Propyl)₂
(Ethyl)₃ In NH (Propyl)₂
(Ethyl)₃ In NH (Ethyl)₂
(Ethyl)₃ In NH (sek.Butyl)₂
(Ethyl)₃ In NH₂ (Methyl)

### Beispiel 3

### Expitaxie des (Methyl)₃GaNH(i-Propyl)₂-Adduktes

Das (Methyl)₃GaNH(i-Propyl)₂-Addukt wurde mit AsH₃ in eine Niederdruck-MOCVD-Anlage (1000-2000 Pa) epitaxiert. Die Wachstumstemperaturen lagen zwischen 850 K und 1050 K. Die Elektronenbeweglichkeit der epitaxierten GaAs-Schicht bei 77 K betrug µ₇₇ = 51000 cm²/Vs. Ein Stickstoffeinbau wird nicht beobachtet.

## Patentansprüche

1. Verwendung von metallorganischen Adduktverbindungen der Formel I 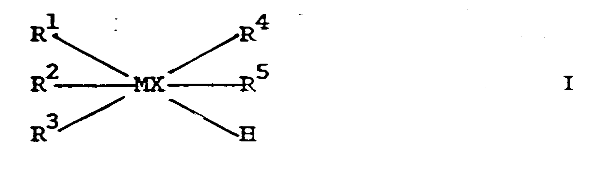 worin
M Aluminium, Gallium oder Indium,
X Stickstoff, Phosphor, Arsen oder Antimon,
R¹, R², R³ und R⁴ jeweils unabhängig voneinander H, eine Alkylgruppe mit 1-8 C-Atomen, die auch teilweise oder vollständig fluoriert sein kann, oder eine Alkenylgruppe mit 3-8 C-Atomen
und
R⁵ eine Alkylgruppe mit 1-8 C-Atomen, die auch teilweise oder vollständig fluoriert kann, oder eine Alkenylgruppe mit 3-8 C-Atomen
bedeuten,
als Ausgangsverbindungen für die Herstellung dünner Filme oder Schichten durch Gasphasenabscheidung.

2. Verwendung von metallorganischen Adduktverbindungen der Formel I nach Anspruch 1 für die Herstellung epitaktischer Schichten.

3. Verfahren zur Herstellung dünner Filme oder Schichten auf Substraten durch Gasphasenabscheidung aus metallorganischen Verbindungen, dadurch gekennzeichnet, daß als metallorganische Ausgangsprodukte die Adduktverbindungen der Formel I 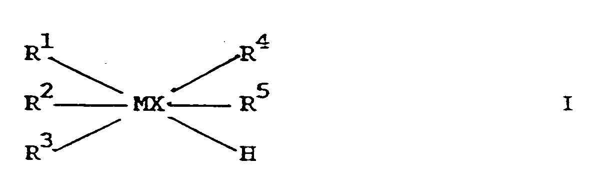 worin R¹, R², R³, R⁴, R⁵, M und X die in Anspruch 1 angegebene Bedeutung haben, eingesetzt werden.

4. Verfahren nach Anspruch 3, dadurch gekennzeichnet, daß man zur Herstellung von Verbindungshalbleitern, elektronischen und optoelektronischen Bauteilen während des Abscheidungsprozesses eine oder mehrere unter den angewandten Reaktionsbedingungen gasförmige Verbindungen des Arsens, Antimons oder Phosphors zuführt.

5. Verfahren nach Anspruch 3, dadurch gekennzeichnet, daß man zusätzlich zu den metallorganischen Adduktverbindungen der Formel I während des Abscheidungsprozesses Dotierstoffe zusetzt.

6. Verfahren nach Anspruch 3, dadurch gekennzeichnet, daß die Adduktverbindungen der Formel I nach Anspruch 1 als Dotierstoffe während des Abscheidungsprozesses von anderen metallorganischen Verbindungen zugesetzt werden.

7. Metallorganische Adduktverbindungen der Formel II 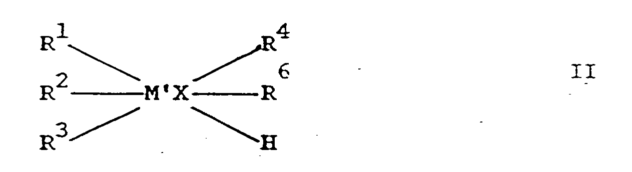 worin
M' Gallium oder Indium,
X Stickstoff, Phosphor, Arsen oder Antimon,
R¹, R², R³ und R⁴ jeweils unabhängig voneinander H, eine Alkylgruppe mit 1-8 C-Atomen, die auch teilweise oder vollständig fluoriert sein kann, oder eine Alkenylgruppe mit 3-8 C-Atomen
und
R⁶ eine verzweigte Alkylgruppe mit 3-8 C-Atomen, die teilweise oder vollständig fluoriert sein kann,
bedeuten.

## Claims

1. The use of organometallic adduct compounds of the formula I 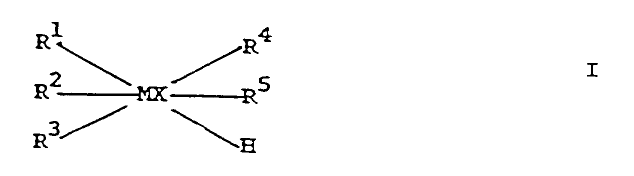 wherein
M is aluminium, gallium or indium,
X is nitrogen, phosphorus, arsenic or antimony,
R¹, R², R³ and R⁴ independently of one another are each H, an alkyl group which has 1-8 C atoms and which can also be partly or completely fluorinated, or an alkenyl group having 3-8 C atoms
and
R⁵ is an alkyl group which has 1-8 C atoms and which can also be partly or completely fluorinated, or an alkenyl group having 3-8 C atoms,
as starting compounds for the production of thin films or layers by gas phase deposition.

2. The use of organometallic adduct compounds of the formula I according to Claim 1 for the production of epitaxic layers.

3. Process for the production of thin films or layers on substrates by gas phase deposition from organometallic compounds, characterized in that the organometallic starting materials employed are the adduct compounds of the formula I 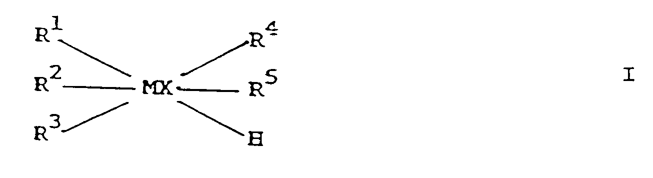 wherein R¹, R², R³, R⁴, R⁵, M and X have the meaning indicated in Claim 1.

4. Process according to Claim 3, characterized in that one or more compounds of arsenic, antimony or phosphorus which are gaseous under the reaction conditions used are introduced during the deposition process in border to produce compound semiconductors or electronic and optoelectronic components.

5. Process according to Claim 3, characterized in that doping agents are added during the deposition process in addition to the organometallic adduct compounds of the formula I.

6. Process according to Claim 3, characterized in that the adduct compounds of the formula I according to Claim 1 are added as doping agents during the process of depositing other organometallic compounds.

7. Organometallic adduct compounds of the formula II 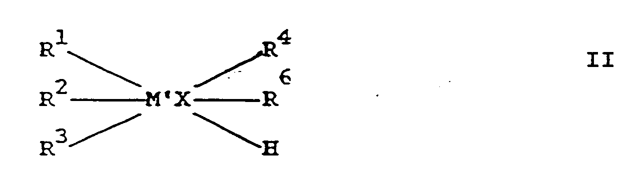 wherein
M' is gallium or indium,
X is nitrogen, phosphorus, arsenic or antimony,
R¹, R², R³ and R⁴ independently of one another are each H, an alkyl group which has 1-8 C atoms and which can also be partly or completely fluorinated, or an alkenyl group having 3-8 C atoms
and
R⁶ is a branched alkyl group which has 3-8 C atoms and which can be partly or completely fluorinated.

## Revendications

1. Utilisation des composés organo-métalliques de formule I 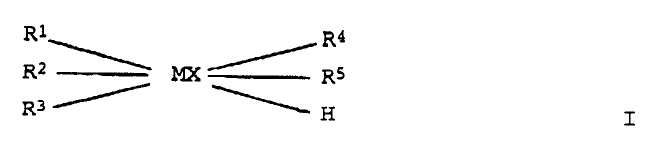 dans laquelle
M représente l'aluminium, le gallium ou l'indium,
X représente l'azote, le phosphore, l'arsénique ou d'antimoine,
R¹, R², R³ et R⁴ représentent chacun indépendamment l'un de l'autre, H un groupe alkyle en C₁ à C₈, qui peut également être partiellement ou entièrement fluoré, ou un groupe alcényle en C₃ à C₈ et
R⁵ représente un groupe alkyle en C₁ à C₈, qui peut également être partiellement ou entièrement fluoré, ou un groupe alcényle en C₃ à C₈,
comme composés de départ pour la préparation de films ou couches minces par séparation en phase gazeuse.

2. Application de composés d'addition organo-métalliques de formule I selon la revendication 1, à la préparation de couches épitactiques.

3. Procédé de préparation de films ou couches minces sur des substrats par séparation en phase gazeuse à partir de composés organo-métalliques, caractérisé en ce qu'on utilise comme produits de départ organo-métalliques les composés d'addition de formule I 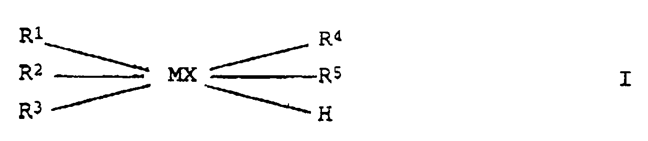 dans laquelle R¹, R², R³, R⁴, R⁵, M et X ont la signification donnée dans la revendication 1.

4. Procédé selon la revendication 3, caractérisé en ce que pour préparer des semi-conducteurs de raccordement, des composants électroniques et optoélectroniques on ajoute au cours du processus de séparation un ou plusieurs composés d'arsenic, d'antimoine ou de phosphore gazeux dans les conditions réactionnelles appliquées.

5. Procédé selon la revendication 3, caractérisé en ce que qu'outre les composés d'addition organo-métalliques de formule I on ajoute pendant le processus de séparation des additifs.

6. Procédé selon la revendication 3, caractérisé en ce que les composés d'addition de formule I selon la revendication 1 sont ajoutés comme additifs au cours du processus de séparation d'autres composés organo-métalliques.

7. Composés organo-métalliques de formule II 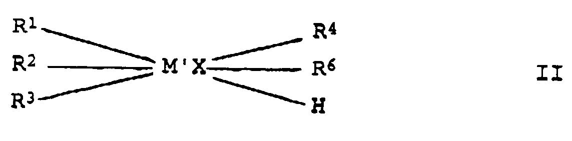 dans laquelle
M' représente le gallium ou l'indium,
X représente l'azote, le phosphore, l'arsenic ou l'antimoine,
R¹, R², R³ et R⁴ représentent chacun indépendamment H, ou un groupe alkyle en C₁ à C₈, qui peut également être partiellement ou entièrement fluoré, ou un groupe alcényle en C₃ à C₈, et
R⁶ représente un groupe alkyle ramifié en C₃ à C₈, qui peut être partiellement ou entièrement fluoré.
